(19)

Europäisches
Patentamt
European
Patent Office
Office européen
des brevets

(11) **EP 2 842 920 A1**

(12) **EUROPEAN PATENT APPLICATION**
published in accordance with Art. 153(4) EPC

(43) Date of publication:
**04.03.2015 Bulletin 2015/10**

(21) Application number: **13781896.9**

(22) Date of filing: **23.04.2013**

(51) Int Cl.:
*C03C 17/25* (2006.01)     *C03C 17/34* (2006.01)
*H01L 31/04* (2014.01)     *H01L 51/50* (2006.01)
*H05B 33/02* (2006.01)     *G02B 5/02* (2006.01)

(86) International application number:
**PCT/JP2013/061947**

(87) International publication number:
**WO 2013/161827 (31.10.2013 Gazette 2013/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **24.04.2012   JP 2012099166**

(71) Applicant: **Asahi Glass Company, Limited
Tokyo 100-8405 (JP)**

(72) Inventors:
• **KUWAHARA, Yuichi
Tokyo 100-8405 (JP)**

• **MORI, Yusuke
Tokyo 100-8405 (JP)**
• **ABE, Keisuke
Tokyo 100-8405 (JP)**
• **YONEDA, Takashige
Tokyo 100-8405 (JP)**

(74) Representative: **Müller-Boré & Partner
Patentanwälte PartG mbB
Friedenheimer Brücke 21
80639 München (DE)**

(54) **METHOD FOR PRODUCING GLASS SUBSTRATE WITH SILICON OXIDE FILM CONTAINING INORGANIC FINE PARTICLES**

(57)     To provide a process for producing a glass substrate provided with an inorganic fine particle-containing silicon oxide film, wherein inorganic fine particles having a desired particle size may be used depending on intended optical properties, and the range of selection of the inorganic fine particles is wide.

A process for producing a glass substrate provided with an inorganic fine particle-containing silicon oxide film, which comprises applying a coating liquid containing inorganic fine particles 14, a hydrolysate of an alkoxysilane, and one of or both water and a (poly)ethylene glycol, to a glass substrate 10 to form an inorganic fine particle-containing silicon oxide film 12; or which comprises forming molten glass into a glass ribbon, annealing the glass ribbon, and at the time of cutting the glass ribbon to obtain a glass substrate, applying a coating liquid containing inorganic fine particles, a hydrolysate of an alkoxysilane, and one of or both water and a (poly)ethylene glycol, to the glass ribbon to form an inorganic fine particle-containing silicon oxide film.

Fig. 1

**Description**

TECHNICAL FIELD

The present invention relates to a process for producing a glass substrate provided with an inorganic fine particle-containing silicon oxide film.

BACKGROUND ART

Glass substrates having concave-convex surface scatter incident light, and such glass substrates are used as window glass having an anti-glare effect, glass substrates for organic EL devices having a light extraction effect, cover glasses for solar cells having a light trapping effect, and so on.

As a glass substrate having a concave-convex surface, a glass substrate having thereon a silicon oxide film having inorganic fine particles contained has been known. As processes for producing such a glass substrate, the following processes, for example, have been proposed.

(1) A process comprising forming metal oxide particles on a glass substrate by a pyrolysis method using a metal chloride as a starting material, and then further forming a silicon oxide film (Patent Document 1).
(2) A process comprising applying a coating liquid containing an organopolysiloxane, inorganic fine particles and a liquid medium to a glass substrate having a temperature within a range of 400 to 650°C to form an inorganic fine particle-containing silicon oxide film (Patent Document 2).

PRIOR ART DOCUMENTS

PATENT DOCUMENTS

Patent Document 1: WO03/080530
Patent Document 2: WO2011/155545

DISCLOSURE OF INVENTION

TECHNICAL PROBLEM

However, when the process of (1) is employed, it is difficult to control the particle size of the metal oxide particles. Accordingly, it is difficult to obtain a glass substrate having intended optical properties.

When the process of (2) is employed, although it is possible to use inorganic fine particles having a desired particle size depending on intended optical properties, since the organopolysiloxane is non-polar, the liquid medium of the coating liquid is limited to non-polar one. Accordingly, the inorganic fine particles are also limited to ones separately subjected to a surface treatment such as hydrophobization so as not to agglomerate in the non-polar liquid medium.

The present invention is to provide a process for producing a glass substrate provided with an inorganic fine particle-containing silicon oxide film, wherein inorganic fine particles having a desired particle size may be used depending on intended optical properties, and the range of selection of the inorganic fine particles is wide.

SOLUTION TO PROBLEM

The present invention provides the following [1] and [2].

[1] A process for producing a glass substrate provided with an inorganic fine particle-containing silicon oxide film, which comprises applying a coating liquid containing inorganic fine particles, a hydrolysate of an alkoxysilane, and one of or both water and a (poly)ethylene glycol, to a glass substrate to form an inorganic fine particle-containing silicon oxide film. Hereinafter, the production process [1] will sometimes be referred to as a process according to a first embodiment of the present invention.

In the invention of [1], the temperature of the glass substrate when the coating liquid is applied is preferably from 200 to 650°C.

Further, it is preferred to further form a metal oxide film having a refractive index different from the inorganic fine particles on the inorganic fine particle-containing silicon oxide film.

[2] A process for producing a glass substrate provided with an inorganic fine particle-containing silicon oxide film, which comprises a step of applying a coating liquid containing inorganic fine particles, a hydrolysate of an alkoxysilane, and one of or both water and a (poly)ethylene glycol, to a glass ribbon formed from molten glass to form an inorganic fine particle-containing silicon oxide film, and then a step of cutting the glass ribbon. Hereinafter, the production process [2] will sometimes be referred to as a process according to a second embodiment of the present invention.

In the invention of [2], the temperature of the glass ribbon when the coating liquid is applied is preferably from 200 to 650°C.

Further, it is preferred that molten glass is formed into a glass ribbon in a float bath, and the coating liquid is applied between the float bath and an annealing step or in the annealing step.

Further, it is preferred to further form a metal oxide film having a refractive index different from the inorganic fine particles, on the inorganic fine particle-containing silicon oxide film on the glass ribbon.

ADVANTAGEOUS EFFECTS OF INVENTION

According to the process for producing a glass substrate provided with an inorganic fine particle-containing silicon oxide film of the present invention, inorganic fine particles having a desired particle size may be used, and the range of selection of the inorganic fine particles is relatively wide.

BRIEF DESCRIPTION OF DRAWINGS

Fig. 1 is a schematic cross-sectional view of an example of the glass substrate provided with an inorganic fine particle-containing silicon oxide film obtained by the production process of the present invention.
Fig. 2 is a schematic cross-sectional view of another example of the glass substrate provided with an inorganic fine particle-containing silicon oxide film obtained by the production process of the present invention.
Fig. 3 is a schematic diagram of an example of a glass production apparatus.

DESCRIPTION OF EMBODIMENTS

In this description, a (poly)ethylene glycol means ethylene glycol or a polyethylene glycol.

In this description, the temperature of a glass substrate or a glass ribbon means a temperature on the side where the coating liquid is applied.

In this description, a refractive index means a refractive index for a light having a wavelength of 550 nm.

In this description, a film thickness of an inorganic fine particle-containing silicon oxide film is measured from an image obtained by observation of a cross-section of a glass substrate provided with an inorganic fine particle-containing silicon oxide film with a scanning electron microscope, and it is the average of the distances between the surface of the glass substrate and the tops of the inorganic fine particles. In this description, a film thickness of a meal oxide film is measured from an image obtained by observation of a cross-section of a glass substrate provided with an inorganic fine particle-containing silicon oxide film having a metal oxide film.

In this description, an average primary particle size in a dispersion means the average primary particle size (median size: 50% particle size) measured by a dynamic scattering method.

<Glass substrate provided with inorganic fine particle-containing silicon oxide film>

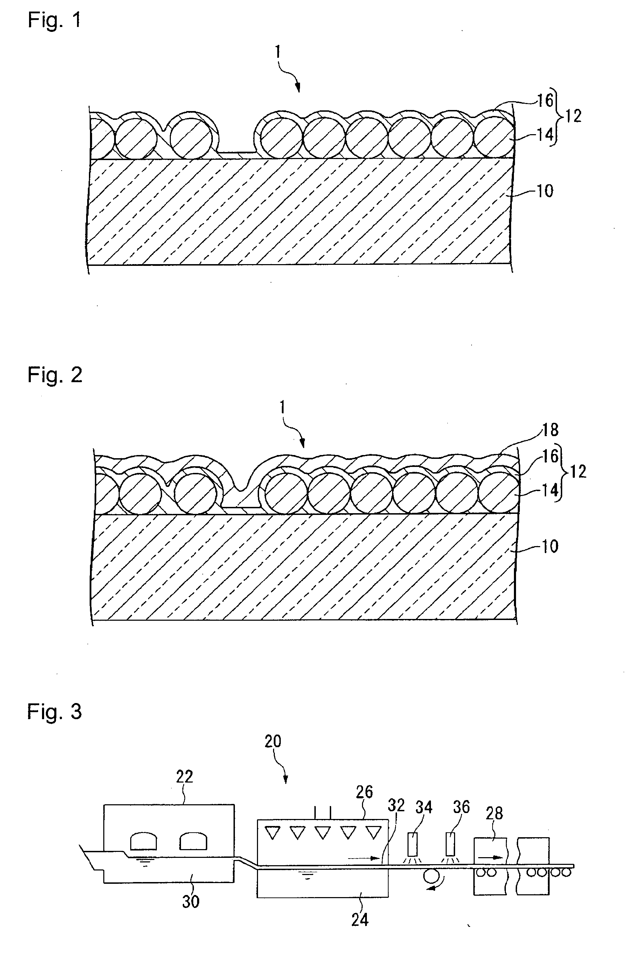

Fig. 1 is a schematic cross-sectional view of an example of the glass substrate provided with an inorganic fine particle-containing silicon oxide film obtained by the production process of the present invention. The glass substrate 1 provided with an inorganic fine particle-containing silicon oxide film comprises a glass substrate 10 and an inorganic fine particle-containing silicon oxide film 12 having a concave-convex surface, which silicon oxide film is formed on the surface of the glass substrate 10.

(Glass substrate)

The material of the glass substrate 10 may, for example, be soda lime silica glass, borosilicate glass or aluminosilicate glass.

In the case where the glass substrate 1 provided with an inorganic fine particle-containing silicon oxide film is used as a glass substrate for an organic EL device, the glass substrate 10 is preferably alkali-free glass or soda lime silica glass, which is coated with silica.

The glass substrate 10 may have a functional layer on the surface of the substrate body. The functional layer may, for example, be an undercoat layer, an adhesion improving layer or a protective layer. The undercoat layer has a function as an alkali barrier layer or a low refractive index layer for wideband. The undercoat layer is preferably a layer formed by applying a coating liquid for undercoat containing an alkoxysilane or a hydrolysate thereof (sol-gel silica) to the surface of the substrate body.

Further, in the production process according to a second embodiment of the present invention, prior to formation of an inorganic fine particle-containing silicon oxide film on the glass ribbon, the above functional film such as an undercoat layer, an adhesion improving layer or a protective layer may be formed.

(Inorganic fine particle-containing silicon oxide film)

The inorganic fine particle-containing silicon oxide film 12 is a film formed by applying the coating liquid (that is, the first coating liquid) which will be described below. Specifically, the inorganic fine particle-containing silicon oxide film 12 is composed of a number of inorganic fine particles 14 disposed on the surface of the glass substrate 10, and a silicon oxide film 16 which thinly covers the surface of the inorganic fine particles 14 and the glass substrate 10, and it has concavities and convexities resulting from the shape of the inorganic fine particles 14, at the surface. The inorganic fine particle-containing silicon oxide film 12 is useful as an anti-glare film for window glass, a light extraction layer of a glass substrate for an organic EL device or a light trapping layer of a cover glass for a solar cell.

The thickness of the inorganic fine particle-containing silicon oxide film 12 is preferably from 100 to 5,000 nm, more preferably from 200 to 1,000 nm. When the thickness of the inorganic fine particle-containing silicon oxide film 12 is at least 100 nm, the anti-glare effect, the light extraction effect, the light trapping effect, etc. due to scattering of light will be good. When the thickness of the inorganic fine particle-containing silicon oxide film 12 is at most 5,000 nm, film forming will not take time excessively, and inconvenience in the production will not be caused.

Coverage of the inorganic fine particles 14 on the glass substrate 10 is preferably from 1 to 100%, more preferably from 5 to 100%. The coverage of the inorganic fine particles 14 is an indication of the deposition efficiency of the inorganic fine particles 14. When the coverage of the inorganic fine particles 14 is at least 1%, the anti-glare effect, the light extraction effect, the light trapping effect, etc. due to scattering of light are good.

The coverage of the inorganic fine particles 14 is obtained as follows.

The concave-convex shape at the surface of the inorganic fine particle-containing silicon oxide film 12 is measured with a measurement length of 1 mm by using a contact level-difference meter. From the measurement result, the length of the part where the inorganic fine particles 14 are present is extracted, and the coverage is obtained from the following formula.

$$\text{Coverage (\%)} = 100 \times \text{length of part where inorganic fine particles 14 are present (mm)} / \text{measurement length (1 mm)}$$

The haze of the glass substrate 1 provided with an inorganic fine particle-containing silicon oxide film is preferably from 0.5 to 100%, more preferably from 2 to 100%. The haze of the glass substrate 1 provided with an inorganic fine particle-containing silicon oxide film is an indication of scattering of light. When the haze of the glass substrate 1 provided with an inorganic fine particle-containing silicon oxide film is at least 0.5, the anti-glare effect, the light extraction effect, the light trapping effect, etc. due to scattering of light are good.

(Inorganic fine particles)

The inorganic fine particles 14 may be metal oxide particles (including composite metal oxide particles) or metal particles. The inorganic fine particles 14 are properly selected depending upon the functions required for the glass substrate 1 provided with an inorganic fine particle-containing silicon oxide film.

When only scattering of light is taken into consideration, the material of the inorganic fine particles 14 is preferably silicon oxide because of its relatively inexpensive price.

Considering imparting another function to the glass substrate 1 provided with an inorganic fine particle-containing silicon oxide film in addition to scattering of light, the material of the inorganic fine particles 14 may, for example, be the following ones, classified according to the function.

Ultraviolet shielding: Zinc oxide, cerium oxide, and the like.

Infrared shielding: Indium tin oxide (ITO), antimony tin oxide (ATO), tungsten oxide, erbium, and the like.

Antistatic: ITO, ATO, silver and the like.

Photocatalyst: Titanium oxide and the like.

Wavelength conversion: Zinc oxide, europium-doped zinc oxide, zinc sulfide, europium-doped zinc sulfide, indium phosphide, bismuth-doped calcium sulfide, europium-doped calcium fluoride, europium-doped yttrium vanadate, and the like.

The shape of the inorganic fine particles 14 may, for example, be spheres, granules, rods, beads, fibers, flakes, hollow particles, aggregates, or indeterminate shape. The inorganic fine particles 14 may be core-shell particles wherein one component is covered with another component. Further, the inorganic fine particles 14 may be surface-treated with a surfactant, a polymer dispersing agent, a silane coupling agent or the like. Further, the inorganic fine particles 14 may be inactive to heat at from 400 to 650°C, that is, they may be one not to be formed into a film, or one having a remarkably low deposition efficiency, when an inorganic fine particle dispersion alone is used as a coating liquid.

(Silicon oxide film)

The silicon oxide film 16 is a fired product of the hydrolysate of the alkoxysilane contained in the coating liquid described below, and it plays a role as a binder to fix the inorganic fine particles 14 to the surface of the glass substrate 10.

(Metal oxide film)

As shown in Fig. 2, the glass substrate 1 provided with an inorganic fine particle-containing silicon oxide film may further have a metal oxide film 18 having a refractive index different from the inorganic fine particles 14, on the inorganic fine particle-containing silicon oxide film 12. The metal oxide film 18 has concavities and convexities derived from the inorganic fine particles 14 on the surface.

The metal oxide film 18 may, for example, be a titanium oxide film (refractive index: 2.5), a zinc oxide film (refractive index: 2.0), a tin oxide film (refractive index: 2.0), a silicon oxide film (refractive index: 1.5) or aluminum oxide (refractive index: 1.8), and it is preferably a titanium oxide film, a zinc oxide film or a tin oxide film since the anti-glare effect, the light extraction effect, the light trapping effect, etc. due to the scattering of light may be sufficiently provided when silicon oxide particles are used as the inorganic fine particles 14. Further, it is possible to use a metal oxide film 18 of a transparent conductive film having a light trapping effect by employing a transparent conductive film such as fluorine-doped tin oxide (FTO), antimony-doped tin oxide (ATO), tin-doped indium oxide (ITO), aluminum-doped zinc oxide (AZO) or gallium doped zinc oxide (GZO) as the metal oxide film 18. The above effect is effectively provided by using a metal oxide film 18 having a refractive index higher than the inorganic fine particles 14. In a case where the external medium is the air (refractive index:1), when the refractive index of the metal oxide film 18 is higher than the inorganic fine particles 14, the scattering properties will improve. On the other hand, when the refractive index of the metal oxide film 18 is lower than the inorganic fine particles 14, due to a refractive index inclined structure, the transmittance will improve. As mentioned above, by changing the refractive index of the metal oxide film, the optical properties may be adjusted depending upon the purpose of use.

The thickness of the metal oxide film 18 is preferably from 100 to 5,000 nm, more preferably from 200 to 1,000 nm. When the thickness of the metal oxide film 18 is at least 100 nm, the anti-glare effect, the light extraction effect, the light trapping effect, etc. due to scattering of light are good. When the thickness of the metal oxide film 18 is at most 5,000 nm, the film-forming does not take excessive time, and inconvenience in production will not cause. To obtain the film thickness, a cross-section of the film is observed with a scanning electron microscope (manufactured by Hitachi High-Technologies Corporation, S-4300), the film thickness is measured at 3 portions within a range of 10 $\mu$m in the out-of-plane direction, and the average is taken as the film thickness.

<Process for producing glass substrate provided with inorganic fine particle-containing silicon oxide film>

The process for producing a glass substrate provided with an inorganic fine particle-containing silicon oxide film of the present invention comprises applying a first coating liquid containing inorganic fine particles, a hydrolysate of an alkoxysilane, and one of or both water and a (poly)ethylene glycol, to a glass substrate or a glass ribbon to be a glass substrate, and firing the hydrolysate of the alkoxysilane to form an inorganic fine particle-containing silicon oxide film on the glass substrate or the glass ribbon.

In the case of forming an inorganic fine particle-containing silicon oxide film on a glass ribbon, the process may specifically, for example, be as follows:

a process comprising a step of applying a coating liquid containing inorganic fine particles, a hydrolysate of an alkoxysilane, and one of or both water and a (poly)ethylene glycol, to a glass ribbon formed from molten glass to form an inorganic fine particle-containing silicon oxide film, and then a step of cutting the glass ribbon.

In the process for producing a glass substrate provided with an inorganic fine particle-containing silicon oxide film of the present invention, a second coating liquid containing a precursor of a metal oxide having a refractive index different from the inorganic fine particles may be applied to the inorganic fine particle-containing silicon oxide film on the glass substrate or the glass ribbon to form a metal oxide film.

(Glass substrate)

The material of the glass substrate may be the ones as described above. Further, the glass substrate is preferably a raw glass substrate which is not reinforced, since it is applied to a process for producing a glass substrate comprising forming molten glass into a glass ribbon, annealing the glass ribbon and cutting it to produce a glass substrate, wherein a coating liquid is applied to the glass ribbon to form an inorganic fine particle-containing silicon oxide film on the glass ribbon.

(First coating liquid)

The first coating liquid contains inorganic fine particles, a hydrolysate of an alkoxysilane, and one of or both water and a (poly)ethylene glycol.

(Inorganic fine particles)

The inorganic fine particles are used in a state of a dispersion wherein the above-described inorganic fine particles are preliminarily dispersed in water or a (poly)ethylene glycol.
The average primary particle size of the inorganic fine particles in the dispersion is preferably from 100 to 1,000 nm, more preferably from 300 to 500 nm. When the average primary particle size of the inorganic fine particles in the dispersion is from 100 to 1,000 nm, the anti-glare effect, the light extraction effect, the light trapping effect, etc. due to scattering of light may be obtained.

(Hydrolysate of alkoxysilane)

The hydrolysate of an alkoxysilane is obtained by hydrolysis of an alkoxysilane by water and a catalyst. The hydrolysate of an alkoxysilane may contain unreacted alkoxysilane.
The alkoxysilane may, for example, be a tetraalkoxysilane (such as tetramethoxysilane, tetraethoxysilane, tetrapropoxysilane or tetrabutoxysilane), a monoalkyltrialkoxysilane (such as methyltrimethoxysilane, methyltriethoxysilane, ethyltrimethoxysilane, ethyltriethoxysilane, propyltrimethoxysilane or propyltriethoxysilane), a dialkyldialkoxysilane (such as dimethyldimethoxysilane, dimethyldiethoxysilane, diethyldimethoxysilane, diethyldiethoxysilane, dipropyldimethoxysilane or dipropyldiethoxysilane), a trialkylmonoalkoxysilane (such as trimethylmethoxysilane, trimethylethoxysilane, triethylmethoxysilane, triethylethoxysilane, tripropylmethoxysilane or tripropylethoxysilane), a monoaryltrialkoxysilane (such as phenyltrimethoxysilane or phenyltriethoxysilane), a diaryldialkoxysilane (such as diphenyldimethoxysilane or diphenyldiethoxysilane), a triarylmonoalkoxysilane (such as triphenylmethoxysilane or triphenylethoxysilane), an alkoxysilane having a perfluoropolyether group (such as perfluoropolyether triethoxysilane), an alkoxysilane having a perfluoroalkyl group (such as perfluoroethyltriethoxysilane), an alkoxysilane having a vinyl group (such as vinyltrimethoxysilane or vinyltriethoxysilane), an alkoxysilane having an epoxy group (such as 2-(3,4-epoxycyclohexyl)ethyltrimethoxysilane, 3-glycidoxypropyltrimethoxysilane, 3-glycidoxypropylmethyldiethoxysilane or 3-glycidoxypropyltriethoxysilane) or an alkoxysilane having an acryloyloxy group (such as 3-acryloyloxypropyltrimethoxysilane).
The alkoxysilane is preferably a tetraalkoxysilane, more preferably tetraethoxysilane or tetramethoxysilane, because of the high hydrolysis rate and the high productivity.
The hydrolysis of the alkoxysilane is carried out by using water, and an acid or an alkali as a catalyst. The acid may be an inorganic acid (such as nitric acid, sulfuric acid or hydrochloric acid) or an organic acid (such as formic acid, oxalic acid, tartaric acid, citric acid, monochloroacetic acid, dichloroacetic acid or trichloroacetic acid). The alkali may, for example, be ammonia, sodium hydroxide or potassium hydroxide. The catalyst is preferably an acid in view of the long-term storage property. Further, the catalyst is preferably one which does not prevent dispersion of the inorganic fine particles.

(Liquid medium)

As the liquid medium of the first coating liquid, one of or both water and a (poly)ethylene glycol are used. If a liquid medium other than water or a (poly)ethylene glycol is used, the inorganic fine particle-containing silicon oxide film may not be deposited on the glass substrate, or the deposition efficiency of the inorganic fine particle-containing silicon oxide film may be significantly decreased.

The liquid medium of the first coating liquid is preferably water only, or a mixture of water and a (poly)ethylene glycol, because the hydrolysis of an alkoxysilane requires water. Further, it is particularly preferably a mixture of a (poly)ethylene glycol and the requisite minimum water because of the good deposition efficiency of the inorganic fine particle-containing silicon oxide film.

The (poly)ethylene glycol may, for example, be ethylene glycol, diethylene glycol, triethylene glycol, tetraethylene glycol or a polyethylene glycol having a molecular weight of at most 300, and it is preferably triethylene glycol or tetraethylene glycol, particularly preferably tetraethylene glycol, because of the good deposition efficiency of the inorganic fine particle-containing silicon oxide film.

The first coating liquid may contain a liquid medium other than water or a (poly)ethylene glycol within a range by which the effect of the present invention is not impaired.

(Composition of first coating liquid)

The solid content concentration of the first coating liquid (the total concentration of the inorganic fine particles and the hydrolysate of the alkoxysilane in the first coating liquid) is preferably from 0.3 to 70 mass%, more preferably from 3 to 25 mass%, from the viewpoint of the deposition efficiency of the inorganic fine particle-containing silicon oxide film and the viscosity (handling properties) of the first coating liquid.

The proportion of the inorganic fine particles is preferably from 1 to 60 mass%, more preferably from 3 to 30 mass%, based on 100 mass% of the solid content of the first coating liquid (the total content of the inorganic fine particles and the hydrolysate of the alkoxysilane in the first coating liquid). When the proportion of the inorganic fine particles is at least 1 mass%, the functions originating from the inorganic fine particles may be sufficiently provided. When the proportion of the inorganic fine particles is at most 60 mass%, agglomeration of the inorganic fine particles can be suppressed, whereby it is possible to obtain a film having the inorganic fine particles uniformly dispersed.

The proportion of the hydrolysate of the alkoxysilane (solid content based on $SiO_2$) is preferably from 40 to 99 mass%, more preferably from 70 to 97 mass%, based on 100 mass% of the solid content of the first coating liquid (the total content of the inorganic fine particles and the hydrolysate of the alkoxysilane in the first coating liquid). When the proportion of the hydrolysate of the alkoxysilane is at least 40 mass%, the inorganic fine particles may be deposited on the film at a higher efficiency. When the proportion of the hydrolysate of the alkoxysilane is at most 99 mass%, the functions originating from the inorganic fine particles may be sufficiently provided.

(Application of first coating liquid)

The method of applying the first coating liquid is preferably a spray method of spraying the first coating liquid by means of a nozzle (for example, a spray gun), with a view to producing a glass substrate provided with an inorganic fine particle-containing silicon oxide film with good production efficiency.

As a specific application method by the spray method, the following methods (i), (ii) and (iii) may, for example, be mentioned, and the method (ii) is preferred in view of the small number of steps and with a view to producing a glass substrate provided with an inorganic fine particle-containing silicon oxide film with better production efficiency.

(i) A method of spraying the first coating liquid over a glass substrate from a nozzle while the nozzle is moved above the fixed glass substrate.
(ii) A method of spraying the first coating liquid over a glass ribbon moving in one direction from a nozzle.
(iii) A method of spraying the first coating liquid over a glass substrate from a nozzle while the nozzle is moved, or fixed, above the moving glass substrate.

The temperature of the glass substrate or the glass ribbon when the first coating liquid is applied is preferably from 200 to 650°C, more preferably from 300 to 600°C. On the glass substrate or the glass ribbon having a temperature within such a range, the hydrolysate of the alkoxysilane is fired and converted to silicon oxide. When the temperature of the glass substrate or the glass ribbon is at least 200°C, the hydrolysate of the alkoxysilane on the glass substrate or the glass ribbon can be fired in a short time, and thus the productivity is good. In the second embodiment of the present invention, in a case where the process for producing a glass substrate by a float process is employed, when the temperature of the glass substrate or the glass ribbon is at most 650°C, the glass ribbon is not present in the float bath, and thus the atmosphere in the float bath will hardly be contaminated during the spraying.

In the second embodiment of the present invention, in a case where the process for producing a glass substrate by a float process is employed, it is preferred to spray the first coating liquid over a glass ribbon obtained by forming molten glass in a float bath, between the float bath and an annealing step or in the annealing step at a position where the glass ribbon is within a temperature range of from 200 to 650°C. In a case where a glass substrate is produced by the float process, the temperature of the glass ribbon at a position immediately after the float bath is usually at a level of 650°C although it depends on the glass composition of the glass substrate. Accordingly, a temperature higher than 650°C of the glass ribbon at a position where the first coating liquid is applied is not realistic. The glass ribbon which has left the float bath is annealed in the annealing step and cooled to 400°C or lower during the annealing step.

(Second coating liquid)

The second coating liquid contains a precursor of a metal oxide and, as the case requires, a liquid medium.

(Precursor of metal oxide)

The precursor of a metal oxide may be the following ones.
Precursor of titanium oxide: titanium alkoxide, titanium alkoxide, titanium acetate, titanium oxyacetylacetonate, titanium acetylacetonate, titanium ethylenediaminetetraacetate, titanium ethylhexanoate, titanium benzoate, titanium lactate, titanium sulfide, titanium fluoride, titanium chloride, titanium bromide, titanium iodide, etc.
Precursor of zinc oxide: zinc acetate; zinc acetylacetonate, zinc ethylenediaminetetraacetate, zinc ethylhexanoate, zinc octadecanoate, zinc benzoate, zinc naphthenate, zinc lactate, zinc sulfide, zinc borate, zinc carbonate, zinc fluoride, zinc chloride, zinc bromide, zinc iodide, etc.
Precursor of tin oxide: tin acetate, dibutyltin diacetate, tin acetylacetonate, tin ethylenediaminetetraacetate, tin ethylhexanoate, tin sulfide, tin fluoride, tin chloride, tin bromide, tin iodide, etc.
Precursor of silicon oxide: a hydrolysate of an alkoxysilane, an organopolysiloxane (such as silicone oil), etc.

(Liquid medium)

The liquid medium of the second coating liquid may be suitably selected depending upon the precursor of the metal oxide.

(Composition of second coating liquid)

The solid content concentration of the second coating liquid (the concentration of the precursor of the metal oxide in the second coating liquid) may be suitably selected depending upon the precursor of the metal oxide.

(Application of second coating liquid)

The method of applying the second coating liquid is preferably a spray method of spraying the second coating liquid by means of a nozzle (for example, a spray gun), with a view to producing a glass substrate provided with an inorganic fine particle-containing silicon oxide film with good production efficiency.
As a specific application method by the spray method, the above methods (i), (ii) and (iii) may, for example, be mentioned, and the method (ii) is preferred in view of the small number of steps and with a view to producing a glass substrate provided with an inorganic fine particle-containing silicon oxide film with better production efficiency.
The temperature of the glass substrate or the glass ribbon when the second coating liquid is applied is preferably from 200 to 650°C, more preferably from 300 to 600°C.
In the second embodiment of the present invention, in a case where the process for producing a glass substrate by a float process is employed, to apply the second coating liquid, it is preferred to spray the second coating liquid over a glass ribbon obtained by forming molten glass in a float bath, between the float bath and an annealing step or in the annealing step at a position where the glass ribbon is within a temperature range of from 200 to 650°C.

(Glass production apparatus)

Fig. 3 is a schematic diagram of an example of the glass production apparatus.
The glass production apparatus 20 comprises a melting furnace 22 in which glass raw materials are melted to obtain molten glass 30, a float bath 26 in which the molten glass 30 is formed into a glass ribbon 32 to be a glass substrate by floating the molten glass 30 supplied from the melting furnace 22 on the surface of molten tin 24, an annealing lehr 28 in which the glass ribbon 32 is annealed, and air-type first spray gun 34 to apply the a first coating liquid which is provided between the outlet of the float bath 26 and the inlet of the annealing lehr 28 at a height of 570 mm above the glass ribbon 32. Further, it is preferred to provide a second spray gun 36 to apply the second coating liquid behind the first spray gun 34.
The first coating liquid is sprayed from the first spray gun 34 over the glass ribbon 32 moving at a prescribed conveying speed, at a position between the float bath 26 and the annealing lehr 28 at which the surface temperature of the glass ribbon 32 is from 200 to 650°C to form an inorganic fine particle-containing silicon oxide film on the glass ribbon 32, and then the second coating liquid is sprayed from the second spray gun 36 over the inorganic fine particle-containing silicon oxide film to form a metal oxide film on the inorganic fine particle-containing silicon oxide film.

The glass ribbon 32 which has left the annealing lehr 28 is cut by a cutting apparatus which is not shown in the Figure to obtain a glass substrate.

(Function and effect)

In the above-described process for producing a glass substrate provided with an inorganic fine particle-containing silicon oxide film of the present invention, a coating liquid containing inorganic fine particles is applied to a glass substrate or a glass ribbon, whereby inorganic fine particles having a desired particle size may be used depending upon intended optical properties. As a result, it is possible to obtain a glass substrate provided with an inorganic fine particle-containing silicon oxide film having the intended optical properties.

Further, in the process for producing a glass substrate provided with an inorganic fine particle-containing silicon oxide film of the present invention, as a precursor of silicon oxide contained in the coating liquid, a hydrolysate of an alkoxysilane is used instead of a conventional organopolysiloxane, whereby a polar medium may be used as the liquid medium. Since there are more kinds of inorganic fine particles capable of being dispersed in a polar liquid medium than inorganic particles capable of being dispersed in a non-polar liquid medium, and since a surface treatment such as hydrophobization is not required to be carried out, the range of selection of the inorganic fine particles becomes wide.

Although a hydrolysate of an alkoxysilane as a precursor of silicon oxide is likely to evaporate at a high temperature as compared with a conventional organopolysiloxane and tends to have a low efficiency of deposition on the glass substrate or the glass ribbon, since in the present invention, one of or both water and a (poly)ethylene glycol are used as a liquid medium, the deposition efficiency of the inorganic fine particle-containing silicon oxide film on the glass substrate or the glass ribbon is good.

Further, by forming the metal oxide film on the inorganic fine particle-containing silicon oxide film, it is possible to produce a glass substrate provided with an inorganic fine particle-containing silicon oxide film having increased antiglare effect, light extraction effect, light trapping effect, etc. due to scattering of light.

EXAMPLES

Now, the present invention will be described in further detail with reference to Examples. However, it should be understood that the present invention is by no means restricted to these Examples.

Examples 8 to 19 are Working Examples, and Examples 1 to 7 are Comparative Examples.

(Coverage)

As an indication of the deposition efficiency, the coverage of the inorganic fine particles on the glass substrate was obtained as follows.

The concave-convex shape at the surface of the inorganic fine particle-containing silicon oxide film was measured with a measurement length of 1 mm by using a contact level-difference meter (DEKTAK150, manufactured by ULVAC). From the measurement result, the length of the part where the inorganic fine particles 14 were present was extracted, and the coverage was obtained from the following formula.

$$\text{Coverage (\%)} = 100 \times \text{length of part where inorganic fine particles are present (mm)} / \text{measurement length (1 mm)}$$

(Haze)

As an indication of scattering of light, the haze of the glass substrate provided with an inorganic fine particle-containing silicon oxide film was measured by means of a haze meter (Haze-gard plus model E-4725, manufactured by BYK-Gardner).

[EXAMPLES 1 to 11]

To a liquid medium shown in Table 1, tetraethoxysilane (manufactured by Kanto Chemical Co., Inc., solid

content based on $SiO_2$: 99.9 mass%) was added so that its concentration would become 30 mass% in the first coating liquid, and nitric acid (70 mass% aqueous solution) was further added so that its concentration would become 0.35 mass% in the first coating liquid, followed by stirring for 1 hour. Then, silica sol (MP-4540M, manufactured by Nissan Chemical Industries, Ltd., average primary particle size: 450 nm, solid content: 40.7 mass%, medium: water) was added so that its concentration would become 2.5 mass% in the first coating liquid, followed by stirring for 5 to 10 minutes to obtain a first coating liquid in each of Examples 1 to 11 wherein the solid content concentration based on $SiO_2$ was 9.65 mass%, the proportion of silicon oxide particles in the solid was 10.4 mass%, and the proportion of the hydrolysate (solid content based on $SiO_2$) of the alkoxysilane in the solid content was 89.6 mass%.

As an application apparatus, KM-100 (manufactured by SPD Laboratory Inc.) was used. As a glass substrate, highly transparent glass (manufactured by Asahi Glass Company, Limited) of 10 cm × 10 cm × 4 mm was used.

The glass substrate was placed on a stage, and a heater was provided on the rear side of the stage without being in contact with the stage. The glass substrate was heated to 600°C via the stage by the radiant heat of the heater. The temperature of the glass substrate was measured by bringing a thermocouple in contact with a side surface of the glass substrate. Since the glass substrate was heated for a sufficient time before the first coating liquid was sprayed by a spray gun, the temperature measured at this position can be considered to be substantially the same as the surface temperature of the glass substrate.

After the glass substrate was heated to 600°C, the first coating liquid was sprayed over the glass substrate from a spray gun provided above the glass substrate. When the first coating liquid was sprayed from the spray gun, the liquid-sending pressure to the spray gun was adjusted so that the liquid-sending rate would be from 0.3 to 0.6 mL/sec, and the spraying pressure was set to be 0.1 MPa. The application time was 15 seconds. Spraying was carried out in a state where the stage, the glass substrate and the spray gun were surrounded by an explosion-proof apparatus, and the ambient temperature was not adjusted.

The coverage and haze of the obtained glass substrate provided with a silicon oxide particle-containing silicon oxide film in each of Examples 1 to 11 are shown in Table 1.

TABLE 1

| Ex. | Liquid medium | Coverage (%) | Haze (%) |
|---|---|---|---|
| 1 | Ethanol | 0 | 0.09 |
| 2 | 2-Propanol | 0 | 0.05 |
| 3 | 4-Hydroxy-4-methyl-2-pentanone | 0 | 0.21 |
| 4 | Dipropylene glycol monomethyl ether | 0 | 0.16 |
| 5 | Hexylene glycol | 0 | 0.10 |
| 6 | 1,4-Butanediol | 0 | 0.36 |
| 7 | Dipropylene glycol | 0 | 0.27 |
| 8 | Water | 18.6 | 3.42 |
| 9 | Ethylene glycol | 7.0 | 2.77 |
| 10 | Triethylene glycol | 26.3 | 8.63 |
| 11 | Tetraethylene glycol | 59.3 | 15.97 |

In Examples 8 to 11 which are Examples of the present invention wherein water or a (poly)ethylene glycol was used as the main liquid medium, high particle coverages were obtained as compared with Examples 1 to 7 wherein another liquid medium was used. Further, in line with the increase in the coverage, the haze was also increased, and high light scattering properties were provided.

[EXAMPLES 12 to 14]

A glass substrate provided with a silicon oxide particle-containing silicon oxide film was obtained in the same manner as in Examples 1 to 11 using the liquid medium in Example 10 except that the temperature of the glass substrate was changed to 300°C, 400°C or 500°C as identified in Table 2. The coverage and the haze of the obtained glass substrate provided with a silicon oxide particle-containing silicon oxide film are shown in Table 2.

TABLE 2

| Ex. | Temperature of glass substrate (°C) | Boiling point of liquid medium (°C) | Coverage (%) | Haze (%) |
|---|---|---|---|---|
| 12 | 300 | 288 | 81.1 | 18.1 |
| 13 | 400 | 288 | 92.0 | 23.8 |
| 14 | 500 | 288 | 59.2 | 16.1 |
| 10 | 600 | 288 | 26.3 | 8.63 |

[EXAMPLE 15 to 19]

To triethylene glycol, tetraethoxysilane (manufactured by Kanto Chemical Co., Inc., solid content based on $SiO_2$: 99.9 mass%) was added so that its concentration would become 30 mass% in the first coating liquid, and nitric acid (70 mass% aqueous solution) was further added so that its concentration would become 0.35 mass% in the first coating liquid, followed by stirring for 1 hour. Then, silica sol (MP-2040, manufactured by Nissan Chemical Industries, Ltd., average primary particle size: 190 nm, solid content: 40 mass%, medium: water) was added so that its concentration would become 2.5 mass% in the first coating liquid, followed by stirring for 5 to 10 minutes to obtain a first coating liquid in each of Examples 15 to 19 wherein the solid content concentration based on $SiO_2$ was 9.65 mass%, the proportion of silicon oxide particles in the solid was 10.4 mass%, and the proportion of the hydrolysate (solid content based on $SiO_2$) of the alkoxysilane in the solid was 89.6 mass%.

To normal decane, silicone oil (X-22-7322, manufactured by Shin-Etsu Silicone) was added so that its proportion would be 70 mass% in the second coating liquid, followed by stirring for 10 minutes to obtain a second coating liquid of Example 16.

To acetylacetone, titanium tetrabutoxide was added so that its concentration would be 20 mass% in the second coating liquid, followed by stirring for 1 hour to obtain a second coating liquid of Example 17.

To N,N-dimethylformamide, zinc acetate dihydride was added so that its concentration would be 20 mass% in the second coating liquid, followed by stirring for 30 minutes to obtain a second coating liquid of Example 18.

To N,N-dimethylformamide, dibutyltin diacetate (a precursor of tin oxide) was added so that its concentration would be 20 mass% in the second coating liquid, followed by stirring for 10 minutes to obtain a second coating liquid of Example 19.

In the same manner as in Example 1, after the glass substrate was heated to 600°C, the first coating liquid was sprayed over the glass substrate from a spray gun provided above the glass substrate. When the first coating liquid was sprayed from the spray gun, the liquid-sending pressure to the spray gun was adjusted so that the liquid-sending rate would be from 0.3 to 0.6 mL/sec, and the spraying pressure was set to be 0.1 MPa. The application time was 15 to 30 seconds.

With respect to Example 15, the glass substrate having only a silicon oxide particle-containing silicon oxide film formed was evaluated. The haze is shown in Table 3.

With respect to Examples 16 to 19, subsequent to the formation of the silicon oxide particle-containing silicon oxide film, a metal oxide film was further formed using each of the above second coating liquids as follows.

While the glass substrate immediately after formation of the silicon oxide particle-containing silicon oxide film was maintained at 600°C, the second coating liquid was sprayed over the silicon oxide particle-containing silicon oxide film from a spray gun provided above the glass substrate. When the second coating liquid was sprayed from the spray gun, the liquid-sending pressure to the spray gun was adjusted so that the liquid-sending rate would be from 0.3 to 0.6 mL/sec, and the spraying pressure was set to be 0.1 MPa. The application time was 15 to 30 seconds.

The glass substrate having a metal oxide film formed on the silicon oxide particle-containing silicon oxide film in each of Examples 16 to 19 was evaluated. The haze is shown in Table 3.

TABLE 3

| Ex. | First layer | | Second layer | | | Haze (%) |
|---|---|---|---|---|---|---|
| | Average primary particle size of silicon oxide particles (nm) | Refractive index | Metal oxide | Refractive index | Thickness (nm) | |
| 15 | 190 | 1.5 | - | - | - | 8.1 |
| 16 | 190 | 1.5 | Silicon oxide | 1.5 | 200 | 2.3 |

(continued)

| Ex. | First layer | | Second layer | | | Haze (%) |
| --- | --- | --- | --- | --- | --- | --- |
| | Average primary particle size of silicon oxide particles (nm) | Refractive index | Metal oxide | Refractive index | Thickness (nm) | |
| 17 | 190 | 1.5 | Titanium oxide | 2.5 | 200 | 44.2 |
| 18 | 190 | 1.5 | Zinc oxide | 2.0 | 200 | 33.4 |
| 19 | 190 | 1.5 | Tin oxide | 2.0 | 200 | 29.3 |

As compared with the glass substrate (Example 15) having only a silicon oxide particle-containing silicon oxide film formed, the glass substrates (Examples 17 to 19) further having formed a metal oxide film having a refractive index different from the silicon oxide particles had substantially improved haze. With regard to the glass substrate (Example 16) further having a silicon oxide film having the same refractive index as the silicon oxide particles formed, no improvement of haze was observed.

INDUSTRIAL APPLICABILITY

The glass substrate provided with an inorganic fine particle-containing silicon oxide film obtained by the production process of the present invention is useful as window glass having an anti-glare effect, a glass substrate for an organic EL device having a light extraction effect, a cover glass for a solar cell having a light trapping effect, and so on.

The entire disclosure of Japanese Patent Application No. 2012-099166 filed on April 24, 2012 including specification, claims, drawings and summary is incorporated herein by reference in its entirety.

REFERENCE SYMBOLS

1: Glass substrate provided with inorganic fine particle-containing silicon oxide film
10: Glass substrate
12: Inorganic fine particle-containing silicon oxide film
14: Inorganic fine particles
16: Silicon oxide film
18: Metal oxide film
20: Glass production apparatus
22: Melting furnace
24: Molten tin
26: Float bath
28: Annealing lehr
30: Molten glass
32: Glass ribbon
34: First spray gun
36: Second spray gun

Claims

1. A process for producing a glass substrate provided with an inorganic fine particle-containing silicon oxide film, which comprises applying a coating liquid containing inorganic fine particles, a hydrolysate of an alkoxysilane, and one of or both water and a (poly)ethylene glycol, to a glass substrate to form an inorganic fine particle-containing silicon oxide film.

2. The production process according to Claim 1, wherein the temperature of the glass substrate when the coating liquid is applied is from 200 to 650°C.

3. The production process according to Claim 1 or 2, which further comprises forming a metal oxide film having a refractive index different from the inorganic fine particles on the inorganic fine particle-containing silicon oxide film.

4. A process for producing a glass substrate provided with an inorganic fine particle-containing silicon oxide film, which comprises a step of applying a coating liquid containing inorganic fine particles, a hydrolysate of an alkoxysilane, and one of or both water and a (poly)ethylene glycol, to a glass ribbon formed from molten glass to form an inorganic fine particle-containing silicon oxide film, and then a step of cutting the glass ribbon.

5. The production process according to Claim 4, wherein the temperature of the glass ribbon when the coating liquid is applied is from 200 to 650°C.

6. The production process according to Claim 4 or 5, wherein molten glass is formed into a glass ribbon in a float bath, and the coating liquid is applied between the float bath and an annealing step or in the annealing step.

7. The production process according to any one of Claims 4 to 6, which further comprises forming a metal oxide film having a refractive index different from the inorganic fine particles, on the inorganic fine particle-containing silicon oxide film on the glass ribbon.

Fig. 1

Fig. 2

Fig. 3

**INTERNATIONAL SEARCH REPORT**

| International application No. |
| --- |
| PCT/JP2013/061947 |

A. CLASSIFICATION OF SUBJECT MATTER
*C03C17/25*(2006.01)i, *C03C17/34*(2006.01)i, *H01L31/04*(2006.01)i, *H01L51/50*
(2006.01)i, *H05B33/02*(2006.01)i, *G02B5/02*(2006.01)n

According to International Patent Classification (IPC) or to both national classification and IPC

B. FIELDS SEARCHED

Minimum documentation searched (classification system followed by classification symbols)
C03C17/00-17/44

Documentation searched other than minimum documentation to the extent that such documents are included in the fields searched
    Jitsuyo Shinan Koho         1922-1996   Jitsuyo Shinan Toroku Koho   1996-2013
    Kokai Jitsuyo Shinan Koho   1971-2013   Toroku Jitsuyo Shinan Koho   1994-2013

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>A | JP 2005-194169 A (Asahi Glass Co., Ltd.),<br>21 July 2005 (21.07.2005),<br>claims; paragraphs [0053], [0065] to [0068]<br>& EP 1524247 A1<br>claims; paragraphs [0027], [0056] to [0061]<br>& US 2005/0084718 A1 | 1,3,4,7<br>2,5,6 |
| E,X | JP 2013-136496 A (Nippon Sheet Glass Co., Ltd.),<br>11 July 2013 (11.07.2013),<br>claims; paragraphs [0086] to [0090]<br>(Family: none) | 1 |

☐  Further documents are listed in the continuation of Box C.    ☐  See patent family annex.

| | |
| --- | --- |
| *   Special categories of cited documents:<br>"A"   document defining the general state of the art which is not considered   to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search<br>    24 July, 2013 (24.07.13) | Date of mailing of the international search report<br>    06 August, 2013 (06.08.13) |
| --- | --- |
| Name and mailing address of the ISA/<br>    Japanese Patent Office | Authorized officer |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03080530 A
- WO 2011155545 A
- JP 2012099166 A